# EUROPEAN PATENT APPLICATION

(11) **EP 4 184 550 A1**
(43) Date of publication of application: **24.05.2023**
(21) Application number: 21896282.7
(22) Date of filing: 17.06.2021
(51) Int. Cl.: H01J 37/32

(54) **DUAL-WALL MULTI-STRUCTURE QUARTZ CYLINDER DEVICE**

(30) Priority: 30.11.2020 CN 202011378056
(71) Applicant: Jiangsu Leuven Instruments Co. Ltd, Xuzhou, Jiangsu 221300 (CN)
(72) Inventor: LIU, Haiyang, Xuzhou, Jiangsu 221300 (CN); HU, Dongdong, Xuzhou, Jiangsu 221300 (CN); LIU, Xiaobo, Xuzhou, Jiangsu 221300 (CN); CHENG, Shiran, Xuzhou, Jiangsu 221300 (CN); GUO, Song, Xuzhou, Jiangsu 221300 (CN); ZHANG, Xiao, Xuzhou, Jiangsu 221300 (CN); CHEN, Lu, Xuzhou, Jiangsu 221300 (CN); XU, Kaidong, Xuzhou, Jiangsu 221300 (CN)
(74) Representative: dompatent von Kreisler Selting Werner - Partnerschaft von Patent- und Rechtsanwälten mbB
(86) International application number: PCT/CN2021/100677
(87) International publication number: WO 2022/110774

(57) **Abstract**

A double-wall multi-structure quartz cylinder device, belonging to the technical field of ion beam etching. Said device specifically comprises a quartz cylinder outer wall, at least one quartz cylinder inner liner being provided inside the quartz cylinder outer wall, axes of the two coinciding with each other, and a quartz cylinder inner liner support being connected between the quartz cylinder inner liner and the quartz cylinder outer wall. The quartz cylinder outer wall and the bottom of the quartz cylinder inner liner are connected to a grid mesh, most of etching by-products will be sputtered onto an inner surface of the quartz cylinder inner liner through voids of the grid mesh, and less etching by-products will be attached to an inner wall of the quartz cylinder outer wall, such that the whole radio frequency circuit is less affected by contamination. In other words, the etching rate is less affected by contamination, prolonging the service life of the quartz tube device, reducing the etching cost, and increasing the MTBC time of ion beam etching.

## Description

### TECHNICAL FIELD

The present disclosure relates to the technical field of ion beam etching, and in particular to a dual-wall multi-structure quartz cylinder device.

### BACKGROUND

With the development of semiconductor devices, the precision of wafer graphics is getting higher and higher. Due to the inevitable lateral drilling, the conventional wet etching can no longer satisfy the requirements for high-precision fine-line graphics etching, and therefore, a series of dry etching techniques have been gradually developed. Plasma etching, reactive ion etching, bipolar sputtering etching, and ion beam etching are widely used. Both the plasma etching and the reactive ion etching are inseparable from reactive gases. The etching of different materials requires different reactive gases and components, as well as different excitation modes and conditions. The reactive gases are generally chloride or fluoride, and it is difficult to find a suitable reactive gas for materials, such as Pt, which is often etched by pure physical effects of bipolar sputtering etching or ion beam etching.

In ion beam etching, ions are provided by an ion source, which has a low ion energy, a high density, a little damage to the substrate and a fast etching rate. Since ion beam etching is not selective to materials, it is especially suitable for some materials that are difficult to be thinned by chemical grinding and dielectric grinding. In addition, ion beam etching is anisotropic corrosion, so the accuracy on the graphics transfer is high, the loss on the line width of the thin lines is small; in ion beam etching, only argon is used and no reactive gas is needed, which has a process safety, a small environmental pollution, and a low operation cost, especially suitable for materials that are difficult to be etched by chemical methods and precise ultra-thin film etching.

Ion beam etching machine is a kind of high vacuum etching equipment, which adopts physical etching method, generates ion beams by using a special ion source, and can achieve anisotropic etching on any material by the accelerated ion beams. When the material substrate is used for etching, there is a layer of mask material on the surface of the material substrate, on which there are patterns that have been photolithographed, the mask material to be removed on the material substrate has been removed, and the ion beams will bombard the part not blocked by the mask material. Ion beam etching machine is mainly used for dry etching of dry etching of metal films such as Au, platinum Pt, NiCr alloy, and copper Cu.

The ion source used in the ion beam etching is generally composed of coils, quartz cylinders, ion source shells and grid meshes, and the grid meshes are composed of screen grids, acceleration grids and deceleration grids. Ion beam etching is generally conducted by extracting ion beams from the grid meshes to etch wafers on the carrier film table. Since ion beam etching is mainly used for etching metal thin films, in this process, the etched by-products will sputter into the inner surface of the quartz cylinder through the void of the grid mesh, forming a contaminated layer on the inner surface of the quartz cylinder. Since most components of the contaminated layer are metal, the contaminated layer has conductive characteristics. As the etching gradually progresses, the contaminated layer is gradually thickened, so that an electric field generated by coils in the quartz cylinder gradually weakens and a density of plasma in the quartz cylinder gradually decreases, until a high power radio frequency applied by the coils can not ignite the quartz cylinder successfully, and eventually, an etching rate of wafer etching process gradually decreases, which greatly shortens the service life of the quartz cylinder, increases the etching cost, and reduces the MTBC time of ion beam etching.

### SUMMARY

In order to solve the above technical problems, the present disclosure provides a dual-wall multi-structure quartz cylinder device.

Technical solutions adopted by the present disclosure to solve the above technical problems are in the following.

Provided is a dual-wall multi-structure quartz cylinder device, comprising a quartz cylinder outer wall, at least one quartz cylinder inner liner is provided inside the quartz cylinder outer wall, and axes of the two are coincided with each other, and quartz cylinder inner liner supports are connected between quartz cylinder inner liners and the quartz cylinder outer wall.

Further, the quartz cylinder outer wall is a tubular structure including a cylinder wall and a top cover.

Further, the central position of the top cover is provided with a gas inlet nozzle.

Further, the gas inlet nozzle is connected to a gas homogenizing plate.

Further, a certain distance is arranged between two adjacent quartz cylinder inner liners.

Further, the quartz cylinder inner liners are bent pieces with bent angles that are consistent with the quartz cylinder outer wall, and bent parts of the bent pieces are parallel to the cylinder wall and the top cover of the quartz cylinder outer wall respectively.

Further, the height of the bent pieces is less than the height of the quartz cylinder outer wall.

Further, the quartz cylinder outer wall and the bottom of the quartz cylinder inner liners are connected to a grid mesh.

Further, the quartz cylinder inner liner supports are connected with the quartz cylinder inner liners and the quartz cylinder outer wall by welding.

Compared with the prior art, the beneficial effects of the present disclosure lie in the following.

The quartz cylinder device is a dual-wall multi-structure, most of etching by-products will be sputtered onto an inner surface of the quartz cylinder inner liner through voids of the grid mesh, and less etching by-products will be attached to an inner wall of the quartz cylinder outer wall, such that the whole radio frequency circuit is less affected by contamination. In other words, the etching rate is less affected by contamination, prolonging the service life of the quartz cylinder device, reducing the etching cost, and increasing the MTBC time of ion beam etching.

The present disclosure will be explained in detail in combination with the accompanying drawings and specific embodiments.

### BRIEF DESCRIPTION OF THE DRAWINGS

FIG. 1 illustrates a structural schematic diagram of an etching system.
FIG. 2 illustrates a basic schematic diagram of the etching system.
FIG. 3 illustrates a structural schematic diagram of a single-wall quartz cylinder in the prior art.
FIG. 4 illustrates a relationship diagram between etching rates of the single-wall quartz cylinder and using duration of the single-wall quartz cylinder.
FIG. 5 illustrates a side sectional view of a quartz cylinder device in the present disclosure.
FIG. 6 illustrates a front top view of the quartz cylinder device in the present disclosure.
FIG. 7 illustrates an axial side view of the quartz cylinder device in the present disclosure.
FIG. 8 illustrates a relationship diagram between etching rates of the quartz cylinder device and using duration of the quartz cylinder in the present disclosure.

### DETAILED DESCRIPTION OF THE EMBODIMENTS

In order to facilitate the understanding of the present disclosure, a more comprehensive description of the present disclosure will be given below with reference to the related drawings. Although several embodiments of the present disclosure are given in the drawings, the present disclosure is capable of being realized in different forms and is not limited to the embodiments described herein; on the contrary, these embodiments are provided to enable the contents disclosed by the present disclosure to be more thorough and comprehensive.

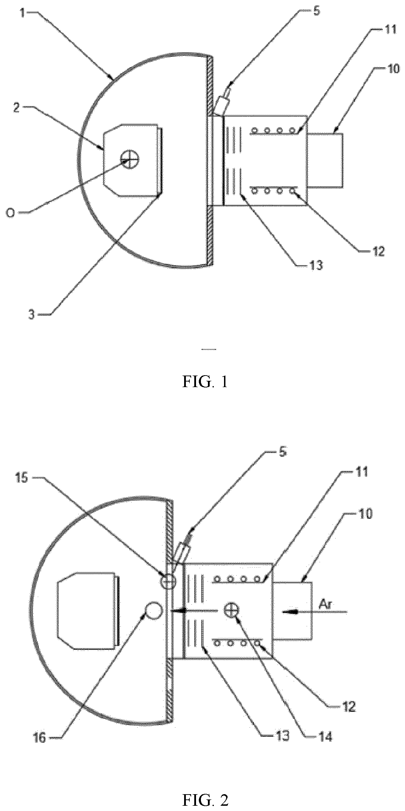

The device is applied to the technology field of ion beam etching, and an etching system is as illustrated in FIG. 1. A lower electrode 2 is located in the middle part of a cavity 1, and a rotating platform 3 is located in the middle part of the lower electrode 2, the lower electrode 2 is rotatable around a central axis O. An ion source 10 is connected with the cavity 1 and can be at a certain angle with the rotating platform 3, and a neutralizer 5 is at a certain angle with the ion source 10, the ion source 10 is composed of a quartz cylinder 11, radio frequency coils 12 and a grid mesh 13, and the grid mesh 13 generally consists of a screen grid, an acceleration grid and a ground grid.

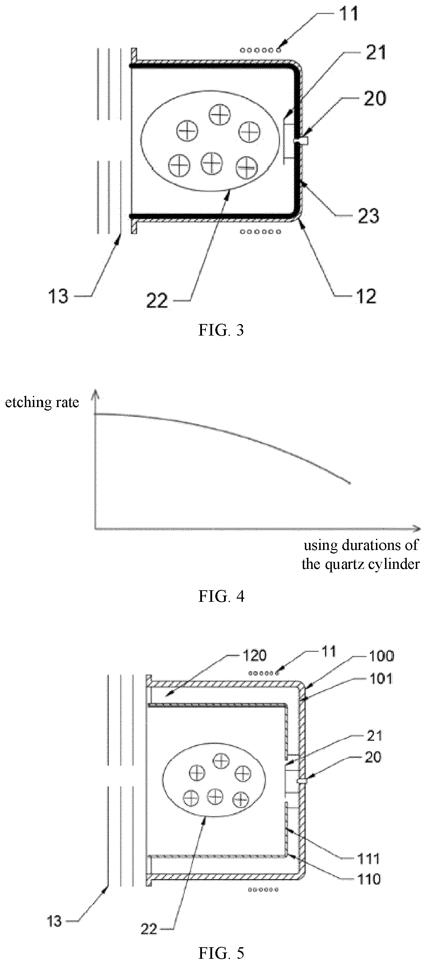

In the existing technical field of ion beam etching, a quartz cylinder device is generally a single-wall structure, as illustrated in FIG. 3 to FIG.4, from which it can be seen that the etched by-products in this process will be sputtered into the inner surface of the single-wall quartz cylinder 12 through the void of the grid mesh 13, resulting in the formation of a contaminated layer 23 on the inner surface of the single-wall quartz cylinder 12. Since most components of the contaminated layer 23 are metal, the contaminated layer 23 has conductive characteristics. At present, as the etching gradually progresses, the contaminated layer 23 is gradually thickened, so that an electric field generated by coils 11 in the single-wall quartz cylinder 12 gradually weakens, and a density of plasma 22 in the single-wall quartz cylinder 12 gradually decreases, until a high power radio frequency applied by the coils 11 can not ignite the single-wall quartz cylinder 12 successfully, and eventually, an etching rate of wafer etching process gradually decreases, which greatly shortens the service life of the single-wall quartz cylinder 12, increases the etching cost, and reduces the MTBC time of ion beam etching.

Since ion beam etching is mainly used for metal film etching, as illustrated in FIG. 3, it can be seen from the structural schematic diagram of the present the single-wall quartz cylinder that the etched by-products in this process will be sputtered into the inner surface of the single-wall quartz cylinder 12 through the void of the grid mesh 13, resulting in the formation of a contaminated layer 23 on the inner surface of the single-wall quartz cylinder 12. Since most components of the contaminated layer 23 are metal, the contaminated layer 23 has conductive characteristics. At present, as the etching gradually progresses, the contaminated layer 23 is gradually thickened, so that an electric field generated by coils 11 in the single-wall quartz cylinder 12 gradually weakens, and a density of plasma 22 in the single-wall quartz cylinder 12 gradually decreases, until a high power radio frequency applied by the coils 11 cannot ignite the single-wall quartz cylinder 12 successfully, and eventually, an etching rate of wafer etching process gradually decreases (as illustrated in FIG. 4 that is a relationship diagram between etching rates and using duration of the quartz cylinder), which greatly shortens the service life of the single-wall quartz cylinder 12, increases the etching cost, and reduces the MTBC time of ion beam etching.

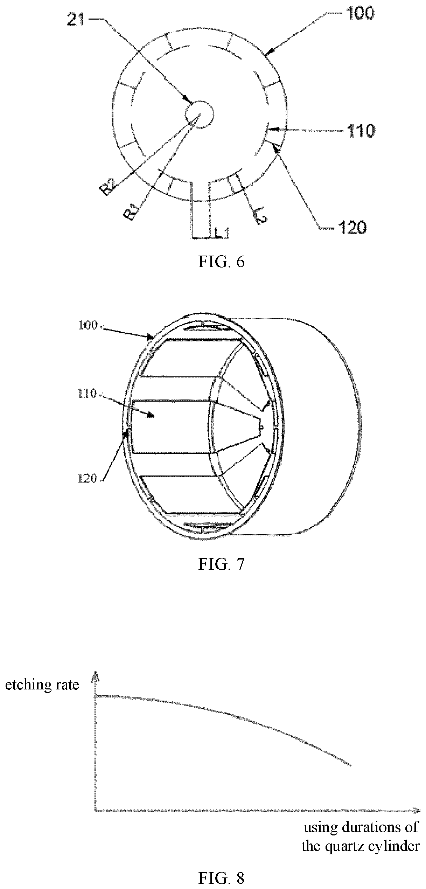

Preferably, the smooth single-wall quartz cylinder in the prior art is designed as a dual-wall multi-structure quartz cylinder in the present disclosure, as illustrated in FIG. 5. The dual-wall multi-structure quartz cylinder in the present disclosure is composed of a quartz cylinder outer wall 100, quartz cylinder inner liners 110 and quartz cylinder inner liner supports 120. The quartz cylinder outer wall 100 and the quartz cylinder inner liners 110 are welded together to form an integral quartz cylinder through the quartz cylinder inner liner supports 120. As illustrated in FIG. 6 to FIG. 7, one or more quartz cylinder inner liners 110 are uniformly or unevenly distributed in the quartz cylinder outer wall 100,the shapes of the quartz cylinder inner liners 110 can be concentric or non-concentric circular arcs with the quartz cylinder outer wall 100, or they can be a plane structure, The embodiments of the present disclosure takes the shape of the quartz cylinder liners 110 as an example, which can be concentric with the quartz cylinder outer wall 100. The distribution drop R1 of the quartz cylinder inner liners 110 is determined by the width L2 of the quartz cylinder inner liner supports 120, L2 can be set according to the process conditions and requirements, the number of the quartz cylinder inner liners 110 and the distance L1 between two quartz cylinder inner liners 110 can also be set according to the process conditions and requirements.

In the above structure, the quartz cylinder outer wall 100 includes a cylinder wall 100a and a top cover 100b, the central position of the top cover 100b is provided with a gas inlet nozzle 20, and the gas inlet nozzle 20 is connected to a gas homogenizing plate 21. The quartz cylinder inner liners 110 are bent pieces with bent angles that are consistent with the quartz cylinder outer wall 100, and bent parts of the bent pieces are parallel to the cylinder wall 100a and the top cover 100b of the quartz cylinder outer wall 100 respectively. It should be noted that the height of the bent pieces is less than the height of the quartz cylinder outer wall 100, and there is a certain distance between two adjacent quartz cylinder inner liners 110, and therefore, the integral structure of the quartz cylinder device is simple and stable.

The basic principles of the etching system designed by the present disclosure are as illustrated in FIG. 2, a gas source Ar enters through a rear inlet nozzle 20 of the ion source 10, and a rear diameter gas homogenizing plate 21 is used to homogenizing the gas, a radio frequency is applied to radio frequency coils 12, and the Ar is stimulated by the radio frequency coils 12 to generate plasma in the quartz cylinder 11, while a voltage is applied to the grid mesh 13. The generated positive charged plasma 14 is accelerated by the grid mesh 13 to bombard the wafer, during this process, neutralizer 5 continuously release an electron 15, and the positive charged plasma 14 and the electron 15 are neutralized into a neutral ion 16, and eventually, the neutral ion 16 bombards the wafer on the rotating platform 3, playing a pure physical etching effect. During this process, in order to ensure the uniformity of etching, the rotating platform 3 rotates around the center axis of the wafer all the time.

The principles of preventing contamination from affecting the quartz cylinder device in the present disclosure lie in the following.

In the whole radio frequency circuit of the original single-wall quartz cylinder structure, the coils 11 are power sources, the plasma 22 is a load, and the inner wall of the quartz cylinder 12 is the radio frequency circuit, and therefore, the influence of the contaminated layer 23 has a great influence on the radio frequency circuit, which is reflected in the great influence on the etching rate. In the whole radio frequency circuit of the dual-wall quartz cylinder of the present disclosure, the coils 11 are power sources, the plasma 22 is the load, and the inner wall of the quartz cylinder outer wall 100 is the radio frequency circuit. Since the quartz cylinder is designed with quartz cylinder inner liners 110, most of the etching by-products will be sputtered onto the inner surface of the quartz cylinder inner liners 110 through voids of the grid mesh 13, less etching by-products will be attached to the inner wall of the radio frequency quartz cylinder outer wall 100, such that the effect of contamination on the whole radio frequency circuit is reduced to extremely low, in other words, the etching rate is less affected by contamination, prolonging the service life of the quartz cylinder device, reducing the etching cost, and increasing the MTBC time of ion beam etching (as illustrated in FIG. 8 that is a relationship diagram between etching rates of the quartz cylinder device and using duration of the quartz cylinder in the present disclosure).

The above exemplary descriptions of the present disclosure are made in combination with the accompanying drawings. It will be apparent that the specific implementations of the present disclosure are not limited by the above methods. As long as such non-substantive improvements are made by adopting the method concepts and technical solutions of the present disclosure, or the concepts and technical solutions of the present disclosure are directly applied to other occasions without any improvement, they are within the protection scope of the present disclosure

## Claims

1. A dual-wall multi-structure quartz cylinder device, comprising a quartz cylinder outer wall (100), at least one quartz cylinder inner liner (110) is provided inside the quartz cylinder outer wall, and axes of the two are coincided with each other, and quartz cylinder inner liner supports (120) are connected between quartz cylinder inner liners (110) and the quartz cylinder outer wall (100).

2. The dual-wall multi-structure quartz cylinder device according to claim 1, wherein the quartz cylinder outer wall (100) is a tubular structure including a cylinder wall (100a) and a top cover (100b).

3. The dual-wall multi-structure quartz cylinder device according to claim 2, wherein a central position of the top cover (100b) is provided with a gas inlet nozzle (20).

4. The dual-wall multi-structure quartz cylinder device according to claim 3, wherein the gas inlet nozzle (20) is connected to a gas homogenizing plate (21).

5. The dual-wall multi-structure quartz cylinder device according to claim 1, wherein a certain distance is arranged between two adjacent quartz cylinder inner liners (110).

6. The dual-wall multi-structure quartz cylinder device according to claim 5, wherein the quartz cylinder inner liners (110) are bent pieces with bent angles that are consistent with the quartz cylinder outer wall (100), and bent parts of the bent pieces are parallel to the cylinder wall (100a) and the top cover (100b) of the quartz cylinder outer wall (100) respectively.

7. The dual-wall multi-structure quartz cylinder device according to claim 6, wherein a height of the bent pieces is less than a height of the quartz cylinder outer wall (100).

8. The dual-wall multi-structure quartz cylinder device according to claim 1, wherein the quartz cylinder outer wall (100) and a bottom of the quartz cylinder inner liners (110) are connected to a grid mesh (13).

9. The dual-wall multi-structure quartz cylinder device according to claim 1, wherein the quartz cylinder inner liner supports (120) are connected with the quartz cylinder inner liners (110) and the quartz cylinder outer wall (100) by welding.
